# Europäisches Patentamt

## European Patent Office

## Office européen des brevets

(19)

(11) **EP 0 862 125 A2**

(12) ## EUROPÄISCHE PATENTANMELDUNG

(43) Veröffentlichungstag:
02.09.1998 Patentblatt 1998/36

(51) Int. Cl.$^6$: **G06F 17/50**

(21) Anmeldenummer: 98102487.0

(22) Anmeldetag: 13.02.1998

(84) Benannte Vertragsstaaten:
**AT BE CH DE DK ES FI FR GB GR IE IT LI LU MC NL PT SE**
Benannte Erstreckungsstaaten:
**AL LT LV MK RO SI**

(30) Priorität: **27.02.1997 AT 330/97**

(71) Anmelder:
**Siemens Aktiengesellschaft Österreich**
**1210 Wien (AT)**

(72) Erfinder:
• **Eiter, Thomas, Dr.**
**1040 Wien (AT)**
• **Gottlob, Georg, Dr.**
**1020 Wien (AT)**

• **Havelka, Thomas**
**1100 Wien (AT)**
• **Stumptner, Markus, Dr.**
**2340-Mödling (AT)**
• **Wotawa, Franz**
**1140 Wien (AT)**
• **Albrecht, Thomas**
**1190 Wien (AT)**
• **Friedrich, Gerhard, Dr.**
**2392 Grub/Wiener Wald (AT)**

(74) Vertreter: **Peham, Alois**
**Siemens AG,**
**Postfach 22 16 34**
**80506 München (DE)**

(54) **Verfahren zum Vergleich elektrischer Signalgruppen**

(57) Es wird ein Verfahren zum Vergleich elektrischer Signalgruppen angegeben, wobei jede Signalgruppe zumindest ein elektrisches Signal umfaßt und wobei die zumindest zwei Signalgruppen in einer vorgegebenen Auswahl überprüft werden, ob sie innerhalb gewisser zeitlicher Toleranzen identisch sind, und/oder ob sie zu ausgewählten Abtastzeitpunkten übereinstimmen, und /oder ob sie funktionell innerhalb gewisser zeitlicher Toleranzen übereinstimmen.

Das Verfahren eignet sich vorzugsweise zur Überprüfung von Modellen unterschiedlicher Abstraktion einer elektrischen Schaltung und damit zur Überprüfung von Entwicklungszwischenergebnissen in einem Top-Down-Entwicklungsprozess. Damit können Designfehler frühzeitig erkannt und Entwicklungszeit und Kosten optimiert werden

1. A waveform trace $\omega$ is a pair $(< S_1, \ldots, S_n >, \tau)$ where $S_1, \ldots, S_n$ denotes a sequence of states consisting out of a set of signal value pairs $(S, V)$, and $\tau$ is a function associating a time point to every state.

For all state indices $i \geq 1$ the condition $\tau(S_i) < \tau(S_{i+1})$ must hold.

2.
$$id(\omega 1, \omega 2, \mu) \Leftrightarrow events(\omega 1) = events(\omega 2) \wedge$$
$$\forall S \in signals(\omega 1) : \forall T \in time(\omega 1) : value(S, T) = value(\mu(S), T)$$

3.
$$idtol(\omega 1, \omega 2, \mu) \Leftrightarrow events(\omega 1) = events(\omega 2) \wedge$$
$$\forall S \in signals(\omega 1) : \forall T \in time(\omega 1) : \exists T' \in time(\omega 2) :$$
$$value(S, T) = value(\mu(S), T') \wedge T' - tol_-(\mu(S)) \leq T \leq T' + tol_+(\mu(S))$$

4.
$$sample(\omega 1, \omega 2, \mu) \Leftrightarrow \forall S \in signals(\omega 1) :$$
$$\forall T \in \{T'|T' = t_{start} + n \cdot \delta, n \in N\} : value(S, T) = value(\mu(S), T)$$

5.
$$func(\omega 1, \omega 2, \mu) \Leftrightarrow \forall i \in \{1, \ldots, n\} : |S_i(\omega 1)| = |S_i(\omega 2)| \wedge$$
$$\forall (S, V) \in S_i(\omega 1) : \exists (\mu(S), V) \in S_i(\omega 2)$$

6. (a)
$$signalTrace(S, \omega) = (< S_1, \ldots, S_n >, \tau) \Leftrightarrow$$
$$\forall i \in \{1, \ldots, n\} : (S, V_i) \in S_i^z(\omega) \wedge$$
$$S_i = \{(S, V_i)\} \wedge \tau(S_i) = \tau(\omega)(S_i^z(\omega))$$

(b)
$$variants(\omega) = \{\omega' | signals(\omega) = signals(\omega') \wedge$$
$$\forall S \in signals(\omega) : idtol(signalTrace(S, \omega), signalTrace(S, \omega'), 1)\}$$

where 1 denotes the identity function.

($t_s$)
$$functol(\omega 1, \omega 2, \mu) \Leftrightarrow \exists \omega \in variants(\omega') : func(\omega', \omega 2, \mu)$$

Fig.1

EP 0 862 125 A2

**Beschreibung**

Die Erfindung betrifft ein Verfahren zum Vergleich elektrischer Signalgruppen, wobei jede Signalgruppe zumindest ein elektrisches Signal umfaßt

Die Entwicklung komplexer elektronischer Schaltungen erfordert systematisches und strukturiertes Vorgehen, um die üblichen hohen Zeit und Qualitätsanforderungen erfüllen zu können. Dabei ist das sogenannte Top-Down-Design üblich, bei dem in einer ersten Stufe lediglich das Ein/Ausgangsverhalten, d.h. die Abhängigkeit der Ausgangssignale von den Eingangssignalen der elektronischen Schaltung beschrieben wird. Die Schaltung selbst wird in dieser Entwicklungsphase als sogenannte Black-Box betrachtet, deren Inneres man nicht kennt, von der man aber weis, daß sie in bestimmter Weise auf gewisse Eingangsbedingungen reagiert.

In weiteren Entwicklungsschritten, deren Anzahl von der Komplexität der elektronischen Schaltung abhängt, wird dann stufenweise die innere Struktur der Schaltung in immer größerer "Auflösung" festgelegt, bis eine Strukturbeschreibung mit unmittelbar realisierbaren Komponenten vorliegt, die direkt in ein elektronisches Bauteil wie z.B. ein ASIC (Anwenderspezifischer IC) umgesetzt werden oder mittels elektronischer Bauteile in eine entsprechende elektronische Schaltungsanordnung übergeführt werden kann.

Obwohl diese Vorgehensweise die Qualität der Entwicklung stark verbessert, treten doch Fehler auf, welche Verzögerungen im Entwicklungsprozeß und erhöhte Kosten mit sich bringen.

Nach der WO 96/19773 wird daher vorgeschlagen, die unterschiedlichen Entwicklungsstufen durch Schaltungsmodelle zu repräsentieren, wobei für jeweils zwei Modelle unterschiedlicher Abstraktion zu bestimmten Eingangssignalen die zugehörigen Ausgangssignale ermittelt werden, die Ausgangssignale der beiden Modelle miteinander verglichen werden und bei Nichtübereinstimmung eine Fehlermeldung generiert wird, und wobei aus der Art der Nichtübereinstimmung und der Information über die Eingangssignale wahrscheinliche Fehler ermittelt und daraus der wahrscheinlichste Fehler abgeleitet werden.

Das genannte Verfahren beruht auf Methoden der „Künstlichen Intelligenz" zur Fehlersuche in Schaltungen, wie sie beispielsweise in „H. E. Shrobe, editor, Exploring Artificial Intelligence: Survey Talks from the National Conferences on Artificial Intelligence, pages 297-346. Morgan Kaufmann, San Mateo, Calif., 1988" beschrieben sind.

Die der vorliegenden Erfindung zugrundeliegende Aufgabe betrifft den Vergleich der Ausgangssignale der beiden Modelle unterschiedlicher Abstraktion, welcher möglichst umfassende Aussagen liefern und so die nachfolgende Fehlerermittlung unterstützen soll. Diese Aufgabe stellt sich über den beschriebenen Anwendungsfall hinaus in allen Fällen, in denen Signale verglichen werden und Aussagen über die Übereinstimmung getroffen werden müssen.

Erfindungsgemäß wird diese Aufgabe gelöst mit einem Verfahren zum Vergleich elektrischer Signalgruppen, wobei jede Signalgruppe zumindest ein elektrisches Signal umfaßt, bei dem die beiden Signalgruppen in einer vorgegebenen Auswahl überprüft werden, ob sie innerhalb gewisser zeitlicher Toleranzen identisch sind, und/oder ob sie zu ausgewählten Abtastzeitpunkten übereinstimmen, und /oder ob sie funktionell funktionell innerhalb gewisser zeitlicher Toleranzen übereinstimmen.

Das erfindungsgemäße Verfahren liefert umfangreiche Aussagen über das Verhältnis zweier Signalgruppen zueinander und bildet somit eine hervorragende Basis für eine erfolgreiche Fehlerermittlung. Das bevorzugte, aber nicht ausschließliche Einsatzgebiet ist das eingangs beschriebene Verfahren zum Testen der Architektur von elektronischen Schaltungen.

Vorteilhaft ist es auch, wenn das Verfahren programmgesteuert abläuft und die Signalgruppen in sogenannten Waveformtracefiles in einem Computer abgebildet sind.

Die Erfindung wird anhand einer Figur näher erläutert, welche beispielhaft Definitionen der einzelnen Vergleichsvorgänge zeigt.

Dazu die folgenden Definitionen: Eine Signalgruppe $\omega$ ist als geordnete Liste einer Abfolge von Wertänderungen $S_1,...,S_n$ einer korrespondierenden Anzahl von Signalen über der Zeit definiert.

Jede Wertänderungsmenge beschreibt eine Veränderung in einer Signalgruppe, d.h. die Zustandsänderung eines oder mehrerer Signale, sie umfaßt Signal-Wert-Paare $(S,V)$ zu jedem Signal einer Signalgruppe. Der Zeitpunkt zu dem diese Änderung auftritt, wird mit einer Zeitfolge $\tau$ erfaßt, die jeder Wertänderungsmenge einen Zeitpunkt zuordnet.

Als Randbedingung gilt dabei, daß die einzelnen Wertänderungsmengen Zustandsänderungen zu unterschiedlichen, jeweils aufeinanderfolgenden Zeitpunkten beschreiben $\tau(S_i) < \tau(S_{i+1})$.

Vorbedingung für einen Vergleich zweier Signalgruppen ist die Übereinstimmung der Bezeichnung der einzelnen Signale der beiden Gruppen. Diese Bezeichnungs-übereinstimmung wird mit einer Abbildungsfunktion $\mu$ hergestellt.

Für den Vergleich sind nun verschiedene Modi vorgesehen. Damit wird die Tatsache berücksichtigt, daß zwei Signalgruppen auch dann als übereinstimmend betrachtet werden können, wenn sie gewisse Unterschiede aufweisen. So können beispielsweise in gewissen Fällen Zeitunterschiede in den Zustandsänderungen, welche die Funktionalität der Schaltung nicht beeinflussen durchaus toleriert werden. In anderen Fällen kann wiederum die Exaktheit des zeitlichen Ablaufes im Vordergrund stehen. All diese Fälle können mit dem erfindungsgemäßen Verfahren zum automatischen Vergleich elektrischer Signalgruppen berücksichtigt werden.

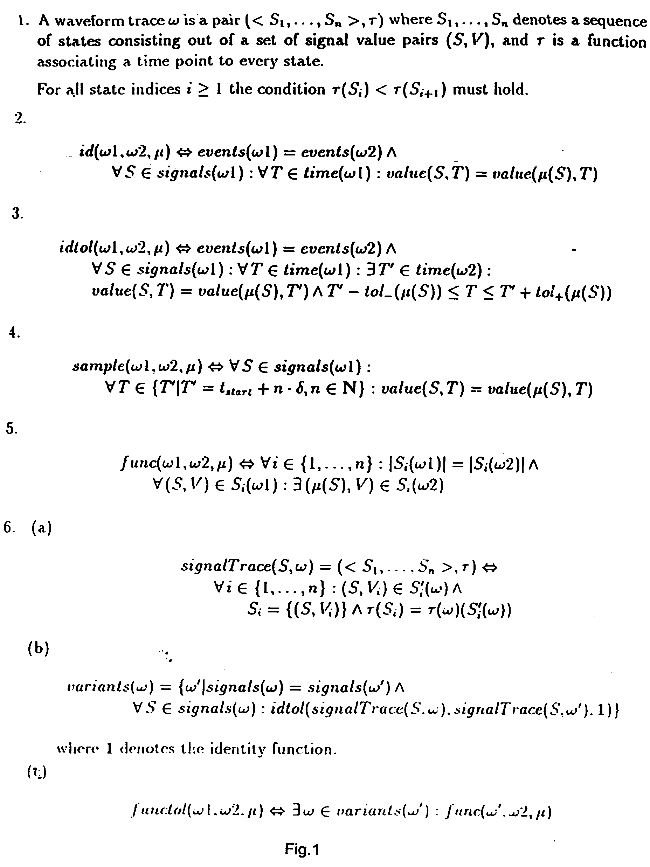

Die Vergleichsmodi werden nun anhand der in der Figur dargestellten formalen Beschreibung näher erläutert. Die Figur umfaßt neben einer allgemeinen Definition 1 die formale Darstellung des identischen Vergleichs 2, des identischen Vergleichs mit Toleranz 3, den Samplevergleich 4, den funktionalen Vergleich 5 und den funktionalen Vergleich mit Toleranz 6.

Beim identischen Vergleich mit zwei Signalgruppen und einer Abbildungsfunktion , werden zwei Signalgruppen dann als übereinstimmend bewertet, wenn jede Wertänderung eines oder mehrerer Signale in einer Signalgruppe zum selben Zeitpunkt auch in der jeweils anderen Signalgruppe auftritt.

Formal wird dies so dargestellt 2, daß Identität $id(\omega 1, \omega 2, \mu)$ dann und nur dann vorliegt, wenn die Anzahl der Wertänderungen in den Signalgruppen übereinstimmt $events(\omega 1) = events(\omega 2)$ und für jedes Signal $S$ der Signalgruppe $signals(\omega 1)$ der Wert des Signals $value(S,T)$ zu jedem Zeitpunkt $T$ übereinstimmt mit dem Wert des korrespondierenden Signals, d.h. des mittels Abbildungsfunktion $\mu$ angeglichenen Signals der verglichenen Signalgruppe $value(S,T) = value(\mu(S),T)$.

Beim Identischen Vergleich mit Toleranz werden zwei Signalgruppen nur dann als übereinstimmend bewertet, wenn zu jeder Wertänderung eines oder mehrerer Signale einer Signalgruppe auch in der jeweils anderen Signalgruppe eine Wertänderung auftritt, und der Zeitunterschied zwischen den beiden Ereignissen einen vorgegebenen Wert nicht überschreitet. Dazu wird zu jeder Wertänderung in der Bezugs-Signalgruppe ein Zeittoleranzfenster definiert, innerhalb dessen die Wertänderung in der anderen Signalgruppe auftreten muß, damit eine Übereinstimmung vorliegt.

Die formale Darstellung 3 der Identität mit Toleranz $idtol(\omega 1, \omega 2, \mu)$ lautet, daß diese dann und nur dann vorliegt, wenn die Anzahl der Wertänderungen in den Signalgruppen übereinstimmt $events(\omega 1) = events(\omega 2)$ und für jedes Signal $S$ der Signalgruppe $signals(\omega 1)$ der Wert des Signals $value(S,T)$ zu jedem Zeitpunkt $T$ übereinstimmt mit dem Wert des korrespondierenden Signals $value(\mu(S),T')$ innerhalb eines vorgegebenen Zeitfensters $T'- tol_-(\mu(S)) <= T <= T'-tol_+(\mu(S))$.

Beim Samplevergleich werden die Signalgruppen zu bestimmten Zeitpunkten hinsichtlich ihrer Übereinstimmung überprüft. Zweckmäßig ist dabei die Definition eines Anfangszeitpunktes zur Festlegung einer Phasenlage und einer Zeitdifferenz zwischen den einzelnen Abtastzeitpunkten bzw. einer Abtastfrequenz.

Formal liegt beim Samplevergleich 4 $sample(\omega 1, \omega 2, \mu)$ dann Übereinstimmung vor, wenn der Wert des Signals $value(S,T)$ zu ausgewählten Zeitpunkten $T$ übereinstimmt mit dem Wert des korrespondierenden Signals $value(\mu(S),T)$ wobei die Zeitpunkte durch einen Anfangszeitpunkt plus ein Vielfaches einer Zeitdifferenz definiert sind

$$T = t_{start} + . n. \ \delta.$$

Beim funktionalen Vergleich wird überprüft, ob die Abfolge der Wertänderungen in den beiden Signalgruppen übereinstimmt. Dabei wird nur festgestellt, ob auch die zeitliche Reihenfolge der einzelnen Wertänderungen übereinstimmt, die absoluten Zeitpunkte bleiben unberücksichtigt.

Die formale Darstellung 5 des funktionalen Vergleichs $func(\omega 1, \omega 2, \mu)$ ergibt dann eine Übereinstimmung, wenn die Zahl der Wertänderungen übereinstimmt $|Si(\omega 1)|=|Si(\omega 2)|$ und für jede Wertänderung $Si$ in $\omega 1$ die in der zeitlichen Reihenfolge entsprechende Wertänderung in $\omega 2$ den selben Betrag aufweist.

Beim funktionalen Vergleich mit Toleranz $functol(\omega 1, \omega 2, \mu)$ wird überprüft, ob die Abfolge der Wertänderungen in den beiden Signalgruppen unter Berücksichtigung eines funktionalen Toleranzfensters übereinstimmt. Dazu werden Signalgruppen-Varianten festgelegt, die als funktional innerhalb dieses Toleranzfensters liegend gelten.

Für die formale Darstellung 6 des funktionalen Vergleiches mit Toleranz $functol(\omega 1, \omega 2, \mu)$ wird eine erste Hilfsfunktion 6(a) $signaltrace (S,\omega)$ definiert, welche für eine bestimmte Signalgruppe $\omega$ und ein gegebenes Signal $S$ nur die Wertänderungen der Signalgruppe $\omega$ darstellt.

Weiterhin wird eine zweite Hilfsfunktion $variants(\omega)$ definiert 6(b); welche alle Signalgruppen $\omega$ umfaßt, die bezüglich der ersten Hilfsfunktion $signaltrace (S,\omega)$ übereinstimmen.

Der eigentliche Vergleich wird dann mittels Formel 6(c) definiert. Zwei Signalgruppen $\omega 1$, $\omega 2$ sind nur dann im Sinne des funktionalen Vergleiches mit Toleranz $functol(\omega 1, \omega 2, \mu)$ als übereinstimmend anzusehen, wenn es eine Variante einer Signalgruppe $variants(\omega')$ gibt, welche funktional mit der zweiten Signalgruppe übereinstimmt

$$\exists \ \omega \ \in variants(\omega'):func(\omega', \omega 2, \mu).$$

Wie bereits angeführt, werden die genannten Vergleichsmodi im Rahmen eines Verfahrens zum Vergleich elektrischer Signalgruppen eingesetzt wobei als Hauptanwendungsgebiet die Überprüfung von Schaltungsentwürfen - Modellen - mit unterschiedlichem Abstraktionsgrad gesehen wird. Damit können frühzeitig im Designprozeß Fehler erkannt werden und Verzögerungen und Kosten vermieden werden.

Die Modelle werden üblicherweise in einer Hardwarebeschreibungssprache wie VHDL abgefaßt. Das Verhalten dieser Modelle wird über Simulationen ermittelt. Dabei wird zu ausgewählten Eingangszuständen - Testvektoren - das Ausgangsverhalten des Modells ermittelt. Dieses Ausgangsverhalten wird mit dem erwarteten Verhalten verglichen und aus etwaigen Differenzen können dann der oder die verursachenden Fehler ermittelt werden.

Nach dem in der WO 96/19773 beschriebenen Verfahren wird als erwartetes Verhalten das Ausgangsverhalten des jeweils übergeordneten - abstrakteren - Modells im Entwicklungsprozeß herangezogen.

Die Ausgangssignale der beiden Modelle können aber aufgrund des unterschiedlichen Abstraktionsgrades Unterschiede aufweisen. Diese können beispielsweise die Anzahl der Signale oder Signalbezeichnungen der Ausgangs-Signalgruppen $\omega1$, $\omega2$ der beiden Modelle betreffen.

Diese Unterschiede können zum Teil mittels Abbildungsfunktion $\mu$ ausgeglichen werden, in vielen Fällen wird man aber zur Erkenntnis gelangen, daß diese Unterschiede mittels funktionalem Vergleich mit Toleranz *functol($\omega1$, $\omega2$, $\mu$)* am besten berücksichtigt werden können.

Üblicherweise werden die genannten Modelle mit Hilfe von Computern erstellt. Auch die Simualtionsvorgänge erfolgen mittels Computer. Die Ausgangs-Signalgruppen $\omega1$, $\omega2$ sind dann in sogenannten Waveformtracefiles abgespeichert.

Zum Vergleich der beiden Waveformtracefiles nach den oben angeführten Modi werden zuerst mit entsprechenden Programmmodulen die notwendigen Daten extrahiert und den Definitionen entsprechend geordnet. So werden aus den Waveformtracefiles insbesondere die Wertänderungsmengen $S_1$, ...$S_n$ und die Zeitfolge $\tau$ als Grundlage für die Vergleichsvorgänge ermittelt. Aus diesen Daten werden dann die weiteren Informationen wie beispielsweise die Anzahl der Wertänderungen in den Signalgruppen *events($\omega1$)*, *events($\omega2$)* und daraus die Vergleichsergebnisse berechnet.

Das Ergebnis der für einen bestimmten Fall vorgesehenen Vergleichsergebnisse wird dann im Rahmen des in der WO 96/19773 beschriebenen Verfahren zur Ermittlung des oder der wahrscheinlichen Fehler herangezogen.

**Patentansprüche**

1. Verfahren zum Vergleich elektrischer Signalgruppen, wobei jede Signalgruppe zumindest ein elektrisches Signal umfaßt, **dadurch gekennzeichnet,** daß die zumindest zwei Signalgruppen in einer vorgegebenen Auswahl überprüft werden, ob sie innerhalb gewisser zeitlicher Toleranzen identisch sind, und/oder ob sie zu ausgewählten Abtastzeitpunkten übereinstimmen, und /oder ob sie funktionell innerhalb gewisser zeitlicher Toleranzen übereinstimmen.

2. Verfahren nach Anspruch 1, **dadurch gekennzeichnet,** daß die beiden Signalgruppen die Ausgangssignale zweier Modelle unterschiedlicher Abstraktion einer elektronischen Schaltung repräsentieren.

3. Verfahren nach Anspruch 1 oder 2, **dadurch gekennzeichnet,** daß das Verfahren programmgesteuert abläuft und die Signalgruppen in sogenannten Waveformtracefiles in einem Computer abgebildet sind.

1. A waveform trace $\omega$ is a pair $(<S_1,\ldots,S_n>,\tau)$ where $S_1,\ldots,S_n$ denotes a sequence of states consisting out of a set of signal value pairs $(S,V)$, and $\tau$ is a function associating a time point to every state.

   For all state indices $i \geq 1$ the condition $\tau(S_i) < \tau(S_{i+1})$ must hold.

2.

$$id(\omega 1,\omega 2,\mu) \Leftrightarrow events(\omega 1) = events(\omega 2) \wedge$$
$$\forall S \in signals(\omega 1) : \forall T \in time(\omega 1) : value(S,T) = value(\mu(S),T)$$

3.

$$idtol(\omega 1,\omega 2,\mu) \Leftrightarrow events(\omega 1) = events(\omega 2) \wedge$$
$$\forall S \in signals(\omega 1) : \forall T \in time(\omega 1) : \exists T' \in time(\omega 2) :$$
$$value(S,T) = value(\mu(S),T') \wedge T' - tol_-(\mu(S)) \leq T \leq T' + tol_+(\mu(S))$$

4.

$$sample(\omega 1,\omega 2,\mu) \Leftrightarrow \forall S \in signals(\omega 1) :$$
$$\forall T \in \{T'|T' = t_{start} + n \cdot \delta, n \in \mathbf{N}\} : value(S,T) = value(\mu(S),T)$$

5.

$$func(\omega 1,\omega 2,\mu) \Leftrightarrow \forall i \in \{1,\ldots,n\} : |S_i(\omega 1)| = |S_i(\omega 2)| \wedge$$
$$\forall (S,V) \in S_i(\omega 1) : \exists (\mu(S),V) \in S_i(\omega 2)$$

6. (a)

$$signalTrace(S,\omega) = (<S_1,\ldots,S_n>,\tau) \Leftrightarrow$$
$$\forall i \in \{1,\ldots,n\} : (S,V_i) \in S_i'(\omega) \wedge$$
$$S_i = \{(S,V_i)\} \wedge \tau(S_i) = \tau(\omega)(S_i'(\omega))$$

   (b)

$$variants(\omega) = \{\omega'|signals(\omega) = signals(\omega') \wedge$$
$$\forall S \in signals(\omega) : idtol(signalTrace(S,\omega),signalTrace(S,\omega'),1)\}$$

   where 1 denotes the identity function.

   (c)

$$functol(\omega 1,\omega 2,\mu) \Leftrightarrow \exists \omega \in variants(\omega') : func(\omega',\omega 2,\mu)$$

**Fig.1**

5